# EUROPÄISCHE PATENTSCHRIFT

(11) **EP 3 201 944 B1**
(45) Veröffentlichungstag und Bekanntmachung des Hinweises auf die Patenterteilung: **21.12.2022**
(21) Anmeldenummer: 15767168.6
(22) Anmeldetag: 24.09.2015
(51) Int. Cl.: H01L 21/762, H01L 21/3105

(54) **KOMBINIERTES WAFERHERSTELLUNGSVERFAHREN MIT EINER MEHRKOMPONENTENAUFNAHMESCHICHT**
COMBINED WAFER PRODUCTION METHOD WITH A MULTI-COMPONENT RECEIVING LAYER
PROCÉDÉ COMBINÉ DE FABRICATION DE TRANCHES AU MOYEN D'UNE COUCHE RÉCEPTRICE À PLUSIEURS CONSTITUANTS

(30) Priorität: 29.09.2014 DE 102014014420
(43) Veröffentlichungstag der Anmeldung: 09.08.2017
(73) Patentinhaber: Siltectra GmbH, 01099 Dresden (DE)
(72) Erfinder: RICHTER, Jan, 01109 Dresden (DE); BEYER, Christian, 09599 Freiberg (DE); AJAJ, Anas, 01069 Dresden (DE)
(74) Vertreter: Müller Hoffmann & Partner
(86) Internationale Anmeldenummer: PCT/EP2015/071949
(87) Internationale Veröffentlichungsnummer: WO 2016/050597

(56) Entgegenhaltungen:
- EP-A2- 2 073 260
- EP-A2- 2 105 972
- US-A1- 2010 289 189
- US-A1- 2011 259 936
- CONG H ET AL: "Photopatternable conductive PDMS materials for microfabrications", ADVANCED FUNCTIONAL MATERIALS, WILEY - V C H VERLAG GMBH & CO. KGAA, DE, vol. 18, no. 13, 9 July 2008 (2008-07-09), pages 1912-1921, XP001514200, ISSN: 1616-301X, DOI: 10.1002/ADFM.200701437

## Beschreibung

Die vorliegende Erfindung bezieht sich auf ein Verfahren zum Herstellen von Festkörperschichten.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Beispielsweise beschreibt die Druckschrift US 2009 / 0 156 016 A1 (EP2073260 A2) ein Verfahren zum Transfer einer dünnen Halbleiterschicht von einem Ausgangssubstrat auf ein Zielsubstrat. Im Ausgangssubstrat wird beispielsweise durch lonenbestrahlung eine Ablöseebene erzeugt. Parallel dazu wird durch UV-Bestrahlung eine dünne Oberflächenschicht einer PDMS(Polydimethylsiloxan)-Folie in Siliziumoxid umgewandelt. Das Ausgangssubstrat wird mit dem Teil, aus dem die dünne Halbleiterschicht hervorgeht, auf die Siliziumoxidschicht der PDMS-Folie gebondet. Das Ausgangssubstrat wird entlang der Ablöseebene abgespalten und die verbleibende dünne Halbleiterschicht auf das Zielsubstrat übertragen. Beim Abspalten und danach stabilisiert die oberflächlich gehärtete PDMS-Folie die dünne Halbleiterschicht. Schließlich wird der nicht gehärtete Teil der PDMS-Folie abgeschält. Der gehärtete Teil der PDMS-Folie wird mit Flusssäure (HF) entfernt.

Die Druckschrift EP 2 105 972 A1 bezieht sich auf die Ausbildung einer Solarzelle in einer dünnen Halbleiterschicht, die von einem einkristallinen Ausgangssubstrat abgespalten wird. Das einkristalline Ausgangssubstrat wird mit Wasserstoffionen bestrahlt. In einer dünnen Schicht, in der sich die implantierten Wasserstoffatome anreichern, wird die Kristallstruktur geschädigt und es formen sich dort Mikrokavitäten. Im Zuge einer Wärmebehandlung bei einer Temperatur von mindestens 410 °C vergrößern sich die Mikrokavitäten und die dünne einkristalline Halbleiterschicht kann vom Ausgangssubstrat abgespalten werden. Nach einem anderen Beispiel wird die Strahlung eines Femtosekundenlasers in einer Ablöseebene fokussiert, wobei Multiphotonenabsorption auftritt, die das einkristalline Halbleitermaterial in der Ablöseebene modifiziert. Eine Wärmebehandlung in einem Ofen oder Heizen mit Mikrowellen spalten die dünne Halbleiterschicht entlang der Ablöseebene vom Ausgangssubstrat ab.

Besonders attraktiv für eine solche Waferherstellung ohne kerf-loss ("kerf-free wafering") erscheinen auch solche Verfahren, die auf das herkömmliche Sägen verzichten indem durch Einsatz von temperaturinduzierten Spannungen direkt dünne Wafer von einem dickeren Werkstück abgespalten werden können.

Beispielsweise beschreibt die Druckschrift US 2010 / 0 289 189 A1 ein solches Verfahren zur Herstellung einer dünnen Festkörperscheibe. Auf eine flache Oberfläche eines Ausgangssubstrats wird ein Polymer aufgebracht. Der Komposit aus dem Ausgangssubstrat und dem Polymer wird bis unter die Raumtemperatur abgekühlt, so dass das Festkörpermaterial entlang einer horizontalen Ablöseebene bricht und dabei eine dünne Festkörperscheibe vom restlichen Ausgangssubstrat abgelöst wird.

Dazu gehören insbesondere auch Verfahren, wie sie z.B. in PCT/US2008/012140, US 2011/259936 A1 und PCT/EP2009/067539 beschrieben sind, wo zum Erzeugen dieser Spannungen ebenfalls eine auf das Werkstück aufgetragene Polymerschicht verwendet wird. Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z.B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vierzähliger Symmetrie zeigt. Die totale Dickenschwankung über den ganzen Wafer gesehen ("total thickness variation", TTV) beträgt bei Verwendung der bisherigen Verfahren häufig mehr als 100% der mittleren Waferdicke (ein Wafer von bspw. 100 Mikrometer mittlerer Dicke, der z.B. an seiner dünnsten Stelle 50 Mikrometer dick und an seiner dicksten Stelle 170 Mikrometer dick ist, hat ein TTV von 170-50=120 Mikrometer, was relativ zu seiner mittleren Dicke einer totalen Dickenschwankung von 120% entspricht). Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören. Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Ferner dauert das Herunterkühlen des Polymers sehr lange, wodurch der Festkörper ebenfalls signifikant temperiert bzw. heruntergekühlt wird und negative Effekte auf den TTV der herzustellenden Festkörperschicht entstehen.

Die Druckschrift EP2105972 A2 beschreibt ein Verfahren zur Erzeugung einer Ablöseebene in einem Festkörper unter Verwendung eines Femtosekunden-Lasers.

CONG H ET AL: "Photopatternable conductive PDMS materials for microfabrications", ADVANCED FUNCTIONAL MATERIALS, WILEY - V C H VERLAG GMBH & CO. KGAA, DE, Bd. 18, Nr. 13, (2008-07-09), Seiten 1912-1921, beschreibt eine PMDS Schicht, in der Ag-Partikel aufgelöst sind.

Es ist somit die Aufgabe der vorliegenden Erfindung ein Verfahren zur Herstellung von Festkörperschichten bereitzustellen, das die Herstellung von Festkörperplatten bzw. Wafern mit einer gleichmäßigen Dicke ermöglicht, insbesondere mit einem TTV von weniger als 120 Mikrometer.

Die zuvor genannte Aufgabe wird durch den Gegenstand der unabhängigen Ansprüche gelöst, die die vorliegende Erfindung definieren. Ausführungsformen, die nicht unter den beanspruchten Gegenstand fallen, stellen keinen Bestandteil der vorliegenden Erfindung dar. Das Verfahren umfasst dabei mindestens die Schritte, die in dem unabhängigen Verfahrensanspruch 1 genannt sind.

Der weitere Werkstoff ist gemäß einer alternativen Ausgestaltung der vorliegenden Erfindung als Beschichtung auf das Polymer aufgebracht oder das Polymer ist als Beschichtung auf den weiteren Werkstoff aufgebracht. Diese Lösung ist vorteilhaft, da das Abkühlen des weiteren Werkstoffs schnell bewirkbar ist und somit durch den unmittelbaren Kontakt zwischen dem weiteren Werkstoff und dem Polymerwerkstoff diesem Wärme entzogen wird, wodurch eine Abkühlung des Polymerwerkstoffanteils der Aufnahmeschicht beschleunigt erfolgt.

Die Beschichtung, d.h. bevorzugt der weitere Werkstoffanteil, weist gemäß einer weiteren bevorzugten Ausführungsform der vorliegenden Erfindung lokale Schwächungen auf, insbesondere ist die Beschichtung gebrochen, insbesondere um einer durch das Polymer bei der Spannungserzeugung bewirkten Verformung zu folgen. Es ist ebenfalls denkbar, dass mit dem weiteren Werkstoff mehrere voneinander verschiedene Abschnitte des Polymeranteils der Aufnahmeschicht beschichtet sind, wobei die einzelnen Werkstoffanteile bevorzugt keine zusammenhängende Struktur ausbilden, sondern besonders bevorzugt zueinander bewegbar sind.

Die Wärmeleitfähigkeit (W/(m*K)) des weiteren Werkstoffs ist gemäß einer weiteren bevorzugten Ausführungsform der vorliegenden Erfindung bevorzugt mehr als 5 mal größer, bevorzugt mehr als 10 mal größer und besonders bevorzugt mehr als 30, mehr als 100, mehr als 200 oder mehr als 300 mal größer als die des Polymers bzw. des Polymerwerkstoffanteils der Aufnahmeschicht, wobei der weitere Werkstoff bevorzugt ein Metall oder eine Legierung ist. Diese Ausführungsform ist vorteilhaft, da mit zunehmender Wärmeleitfähigkeit des weiteren Werkstoffs eine Abkühlung des Polymerwerkstoffanteils der Aufnahmeschicht beschleunigbar ist.

Der weitere Werkstoff ist gemäß einer weiteren alternativen Ausgestaltung der vorliegenden Erfindung in Form von länglichen Spänen oder zapfenartigen Elementen innerhalb einer von dem Polymer vorgegebenen Schichtstruktur vorgesehen, wobei die Späne bevorzugt derart ausgerichtet sind, dass sich ihrer Längsachsen orthogonal zur Schichterstreckungsrichtung erstrecken. Die Späne werden bevorzugt beim Erzeugen der Aufnahmeschicht in das zu diesem Zeitpunkt bevorzugt flüssige Polymer eingebracht und z.B. über eine Magnetbeaufschlagung ausgerichtet. Diese Ausführungsform ist vorteilhaft, da durch die einzelnen Späne jeweils eine Kältebrücke geschaffen wird, durch die dem Polymerwerkstoffanteil der Aufnahmeschicht sehr schnell Wärme entziehbar ist bzw. der Polymerwerkstoffanteil der Aufnahmeschicht sehr schnell abkühlbar ist.

Die Aufnahmeschicht weist gemäß einer weiteren alternativen Ausgestaltung der vorliegenden Erfindung eine Vielzahl an Löcher auf, wobei die Löcher mit dem weiteren Werkstoff gefüllt oder ausgekleidet sind. Diese Ausführungsform ist vorteilhaft, da die Position und/oder Gestalt der durch den weiteren Werkstoff ausgebildeten Kältebrücke sehr genau vorgebbar bzw. erzeugbar ist.

Die Spannungen zum Ablösen der Festkörperschicht von dem Festkörper werden durch die thermische Beaufschlagung der Aufnahmeschicht, insbesondere einer Mehrkomponentenschicht, erzeugt. Die thermische Beaufschlagung stellt ein Abkühlen der Aufnahmeschicht auf oder unter die Umgebungstemperatur und bevorzugt unter 10°C und besonders bevorzugt unter 0°C und weiter bevorzugt unter -10°C dar. Die Abkühlung der Aufnahmeschicht erfolgt derart, dass zumindest der Polymerwerkstoffanteil der Aufnahmeschicht, die zumindest teilweise aus einem Polymerwerkstoff, insbesondere aus PDMS, und aus einem weiteren Werkstoff, insbesondere einem Metall, besteht, einen Glasübergang vollzieht. Die Abkühlung kann hierbei eine Abkühlung auf unter -100°C sein, die z.B. mittels flüssigen Stickstoffs bewirkbar ist. Diese Ausführungsform ist vorteilhaft, da sich die Aufnahmeschicht in Abhängigkeit von der Temperaturveränderung zusammenzieht und/oder einen Gasübergang erfährt und die dabei entstehenden Kräfte auf den Festkörper überträgt, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

Gemäß einer bevorzugten Ausführungsform der vorliegenden Erfindung wird der Festkörper an einer Halteschicht zum Halten des Festkörpers angeordnet, wobei die Halteschicht an einem ersten ebenen Flächenanteil des Festkörpers angeordnet wird, wobei der erste ebene Flächenanteil des Festkörpers von einem zweiten ebenen Flächenanteil des Festkörpers beabstandet ist, wobei am zweiten ebenen Flächenanteil die Aufnahmeschicht angeordnet ist und wobei die Ablöseebene gegenüber dem ersten ebenen Flächenanteil und/oder dem zweiten ebenen Flächenanteil parallel ausgerichtet wird bzw. parallel erzeugt wird.

Diese Ausführungsform ist vorteilhaft, da der Festkörper zumindest abschnittweise und bevorzugt vollständig zwischen der Halteschicht und der Aufnahmeschicht angeordnet ist, wodurch mittels einer dieser Schichten oder mittels beider Schichten die Spannungen zur Risserzeugung bzw. Rissausbreitung in den Festkörper einleitbar sind.

Der Festkörper weist gemäß einer weiteren bevorzugten Ausführungsform der vorliegenden Erfindung Silizium und/oder Gallium oder Perowskit auf und die Polymerschicht und/oder die Halteschicht bestehen zumindest teilweise und bevorzugt vollständig oder zu mehr als 75% (Volumenprozent) aus Polydimethylsiloxane (PDMS), wobei die Halteschicht an einer zumindest abschnittsweise ebenen Fläche einer Stabilisierungseinrichtung angeordnet ist, die zumindest teilweise aus mindestens einem Metall besteht. Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht der Festkörper definiert bzw. fest gehalten wird, wodurch die Spannungen sehr genau in dem Festkörper erzeugt werden können.

Der Festkörper weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7). Gemäß einer weiteren bevorzugten Ausführungsform der vorliegenden Erfindung erfolgt das Fixieren der Aufnahmeschicht an dem Festkörper mittels einer Verbindungsschicht, wobei die Aufnahmeschicht besonders bevorzugt eine Vielzahl an Löcher zum Leiten einer Flüssigkeit aufweist.

Die Löcher weisen einen Durchmesser von weniger als 1mm, bevorzugt von weniger als 0,5mm und besonders bevorzugt von weniger als 0,1mm, auf.

Die Aufnahmeschicht weist gemäß einer weiteren bevorzugten Ausführungsform der vorliegenden Erfindung mehr als 10 Löcher, bevorzugt mehr als 100 Löcher und besonders bevorzugt mehr als 1000 Löcher, auf.

In einem Radius von weniger als 50mm, bevorzugt weniger als 25mm und besonders bevorzugt weniger als 5mm oder von weniger als 4mm oder von weniger als 3mm oder von weniger als 2mm oder von weniger als 1mm oder von weniger als 0,5mm, um das Zentrum eines jeden Loches herum ist gemäß einer weiteren bevorzugten Ausführungsform der vorliegenden Erfindung bevorzugt mindestens ein weiteres Loch ausgebildet.

Zum Ablösen der Aufnahmeschicht von dem Festkörper ist gemäß einer weiteren bevorzugten Ausführungsform der vorliegenden Erfindung ein Fluid, insbesondere eine Flüssigkeit, durch die Löcher der Verbindungsschicht zuführbar, wobei das Fluid bevorzugt bewirkt, dass die Fixierung der Aufnahmeschicht an dem Festkörper geschwächt oder aufgehoben wird.

Mittels mindestens eines Femtosekunden-Lasers werden vor oder nach dem Anbringen der Aufnahmeschicht an dem Festkörper Defekte in der inneren Struktur des Festkörpers zum Vorgeben der Ablöseebene erzeugt.

Die Erfindung bezieht sich ferner auf eine Anordnung mit einer Aufnahmeschicht.

Weiterhin bezieht sich die vorliegende Erfindung auf eine Folie zur Spannungserzeugung in einem Festkörper, die als Aufnahmeschicht, wie sie oben beschrieben wurde, verwendet werden kann.

Weiterhin werden die Gegenstände der Druckschriften PCT/US2008/012140, PCT/EP2009/067539, DE102013016666.7, WO 2013/113730A1 und DE102014013107.6 genannt.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1a: einen schematischen Aufbau zum Erzeugen von Lokal-Spannungen in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: ein Beispiel für eine Aufnahmeschicht;
- Fig. 2b: ein weiteres Beispiel für eine Aufnahmeschicht, die an einem Festkörper angeordnet ist;
- Fig. 2c: eine erfindungsgemäße Aufnahmeschicht, die an einem Festkörper angeordnet ist;
- Fig. 2d: eine weitere erfindungsgemäße Aufnahmeschicht, die an einem Festkörper angeordnet ist; und
- Fig. 2e: eine weitere erfindungsgemäße Aufnahmeschicht, die an einem Festkörper angeordnet ist.

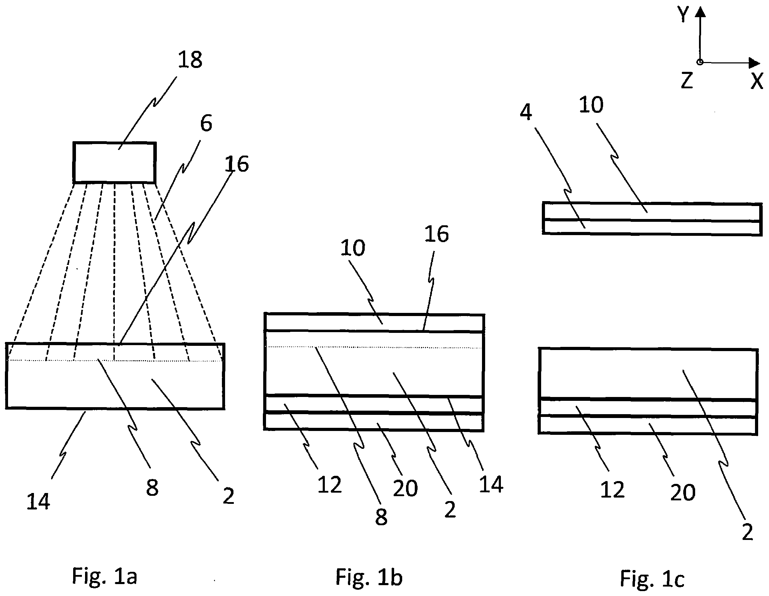

In Fig. 1a ist ein Werkstück 2 bzw. ein Substrat gezeigt, das im Bereich einer Strahlungsquelle 18, im Rahmen der vorliegenden Erfindung im Bereich eines Femtosekundenlasers (fs-Laser), angeordnet ist. Das Werkstück 2 weist bevorzugt einen ersten, insbesondere ebenen, Flächenanteil 14 und einen zweiten, insbesondere ebenen, Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt das Werkstück 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Weiterhin lässt sich dieser Darstellung entnehmen, dass die Strahlungsquelle 18 Stahlen 6 zeitgleich oder zeitversetzt auf das Werkstück 2 ausstrahlt. Die Strahlen 6 dringen je nach Konfiguration definiert tief in das Werkstück 2 ein und erzeugen an der jeweiligen Position bzw. an einer vorbestimmten Position Lokal-Spannungen.

In Fig. 1b ist eine mehrschichtige Anordnung gezeigt, wobei das Werkstück 2 die Rissführungsschicht 8 beinhaltet und im Bereich des ersten ebenen Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten ebenen Flächenanteil 16 des Werkstücks 2 ist bevorzugt eine Polymerschicht 10 angeordnet. Die Aufnahmeschicht bzw. Polymerschicht 10 und/oder die Halteschicht 12 bestehen bevorzugt zumindest teilweise und besonders bevorzugt vollständig aus PDMS und weist besonders bevorzugt eine Vielzahl an Löchern, insbesondere Sacklöcher und/oder Durchgangslöcher, auf.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Werkstücks 2 beabstandet bzw. beabstandbar.

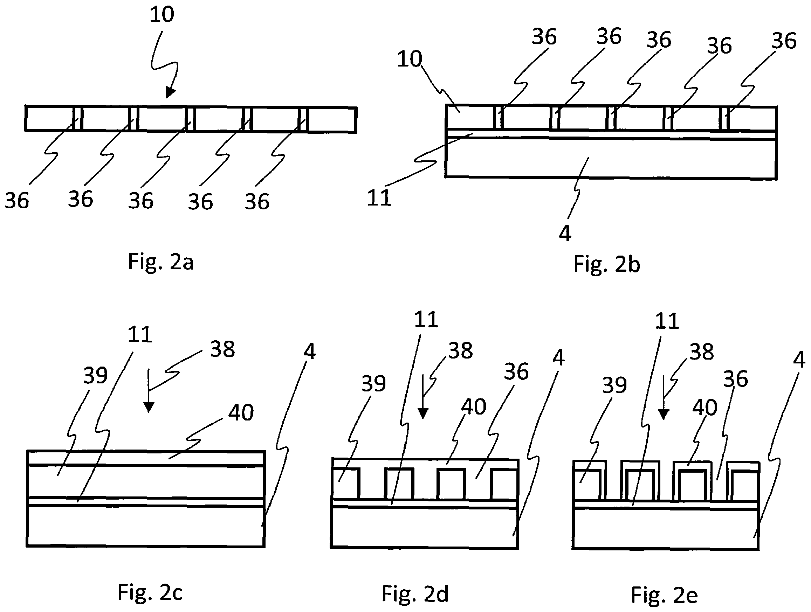

Fig. 2a zeigt ein Beispiel für eine Aufnahmeschicht 10 bzw. Folie zur Spannungserzeugung in einem Festkörper 2. Die Folie weist dabei zumindest einen Polymerwerkstoff insbesondere PDMS, auf, wobei der Polymerwerkstoff einen Glasübergang be einer Temperatur kleiner als 0°C, insbesondere bei einer Temperatur kleiner -50°C, erfährt. Die Folie weist besonders bevorzugt eine Vielzahl an Löcher 36 zum Leiten einer Flüssigkeit auf, wobei die Löcher 36 jeweils einen Durchmesser von weniger als 5mm aufweisen.

Fig. 2b zeigt eine von einem Festkörper 2 abgetrennte Festkörperschicht 4. An der Festkörperschicht 4 ist noch eine Aufnahmeschicht 10 bzw. eine Folie 10 angeordnet, mittels der die zum Erzeugen eines Risses zum Abtrennen der Festkörperschicht 4 vom Festkörper 2 erforderlichen Spannungen erzeugt wurden. Die Aufnahmeschicht 10 weist eine Vielzahl an Löcher zum Leiten einer Flüssigkeit auf, wobei die Aufnahmeschicht 10 mittels einer Verbindungsschicht 11 an der Festkörperschicht 4 fixiert ist.

Fig. 2c zeigt eine erfindungsgemäße Aufnahmeschicht 10 bzw. Folie, die bevorzugt ebenfalls mittels einer Verbindungsschicht 11 an dem Festkörper 2 anordenbar ist bzw. daran angeordnet ist. Die Aufnahmeschicht 10 bzw. Mehrkomponentenaufnahmeschicht weist dabei einen ersten Materialanteil 39, einen Polymeranteil, und einen zweiten Materialanteil 40, insbesondere einen Metallanteil, auf. Der zweite Materialanteil 40 stellt dabei eine Beschichtung des ersten Materialanteils 39 dar und dient besonders bevorzugt zum beschleunigten Abkühlen des ersten Materialanteils 39. Die Aufnahmeschicht 10 wird dabei bevorzugt aus der Richtung 38 mit Kälte, insbesondere flüssigem Stickstoff, beaufschlagt, wodurch der zweite Materialanteil 40 schnell herunterkühlt und insbesondere durch den unmittelbaren Kontakt mit dem ersten Materialanteil 39 dieser ebenfalls sehr schnell abgekühlt wird.

Fig. 2d zeigt eine Variante der erfindungsgemäßen Aufnahmeschicht 10 bzw. Folie, die wiederum durch den ersten Materialanteil 39 und den zweiten Materialanteil 40 gebildet wird. Der erste Materialanteil 39 weist Löcher 36 auf, die durch den zweiten Materialanteil 40 ausgefüllt werden. Bevorzugt beschichtet der zweite Materialanteil 40 den ersten Materialanteil 39 zusätzlich oder alternativ oberseitig, d.h. parallel zur Verbindungsschicht 11.

Fig. 2e zeigt eine weitere Variante der erfindungsgemäßen Aufnahmeschicht 10 bzw. Folie, die wiederum durch den ersten Materialanteil 39 und den zweiten Materialanteil 40 gebildet wird. Der erste Materialanteil 39 weist Löcher 36 auf, die durch den zweiten Materialanteil 40 ausgekleidet werden, d.h. dass die das jeweilige Loch 36 begrenzende Wandung mit dem zweiten Materialanteil 40 beschichtet ist. Bevorzugt beschichtet der zweite Materialanteil 40 den ersten Materialanteil 39 zusätzlich oder alternativ oberseitig, d.h. parallel zur Verbindungsschicht 11.

Ferner ist bevorzugt denkbar, dass das Verfahren zum Herstellen von Festkörperschichten, zumindest die nachfolgend genannten Schritte umfasst: Bereitstellen eines Festkörpers 2 zum Abtrennen mindestens einer Festkörperschicht 4, Fixieren einer Aufnahmeschicht 10 zum Halten der Festkörperschicht 4 an dem Festkörper 2, wobei die Aufnahmeschicht eine Vielzahl an Löcher zum Leiten einer Flüssigkeit aufweist, wobei die Aufnahmeschicht mittels einer Verbindungsschicht an dem Festkörper fixiert wird und thermisches Beaufschlagen der Aufnahmeschicht 10 zum, insbesondere mechanischen, Erzeugen von Spannungen in dem Festkörper 2, wobei sich durch die Spannungen ein Riss in dem Festkörper 2 entlang einer Ablöseebene 8 ausbreitet, wobei durch den Riss die Festkörperschicht 4 von dem Festkörper 2 abgetrennt wird.

Weiterhin weist die erfindungsgemäße Folie zur Spannungserzeugung in einem Festkörper zumindest einen Polymerwerkstoff, insbesondere PDMS, auf, wobei der Polymerwerkstoff einen Glasübergang bei einer Temperatur kleiner als 0°C, insbesondere bei einer Temperatur kleiner -50°C, erfährt. In einer Variante der vorliegenden Erfindung weist die Folie eine Vielzahl an Löchern zum Leiten einer Flüssigkeit auf, wobei die Löcher mit dem weiteren Werkstoff gefüllt oder ausgekleidet sind. Bevorzugt weisen die Löcher jeweils einen Durchmesser von weniger als 5mm aufweisen.

### Bezugszeichenliste

- 2: Werkstück
- 3: Substrat
- 4: Festkörperschicht
- 5: Opferschicht
- 6: Strahlung
- 8: Rissführungsschicht
- 10: Aufnahmeschicht / Folie
- 11: Verbindungsschicht
- 12: Halteschicht
- 14: erster ebener Flächenanteil
- 16: zweiter ebener Flächenanteil
- 18: Strahlungsquelle/Defekterzeugungsvorrichtung
- 20: Stabilisierungseinrichtung
- 36: Loch
- 38: Beaufschlagung mit Kälte
- 39: erster Materialanteil
- 40: zweiter Materialanteil

- X: erste Richtung
- Y: zweite Richtung
- Z: dritte Richtung

## Patentansprüche

1. Verfahren zum Herstellen von Festkörperschichten,
mindestens umfassend die Schritte:
Bereitstellen eines Festkörpers (2) zum Abtrennen mindestens einer Festkörperschicht (4),
Anordnen einer Aufnahmeschicht (10) zum Halten der Festkörperschicht (4) an dem Festkörper (2), wobei die Aufnahmeschicht (10) zumindest aus einem Polymer (39) und einem weiteren Werkstoff (40) besteht, wobei der weitere Werkstoff (40) eine höhere Temperaturleitfähigkeit als das Polymer (39) aufweist,
Erzeugen von Defekten in der inneren Struktur des Festkörpers (2) zum Vorgeben einer Ablöseebene (8) mittels mindestens eines Femtosekunden-Lasers, vor oder nach dem Anbringen der Aufnahmeschicht (10) an dem Festkörper (2),
und danach Abkühlen der Aufnahmeschicht (10) auf oder unter eine Umgebungstemperatur derart, dass ein Polymerstoffanteil der Aufnahmeschicht (10) einen Glasübergang erfährt zum, insbesondere mechanischen, Erzeugen von Spannungen in dem Festkörper (2), wobei sich durch die Spannungen ein Riss in dem Festkörper (2) entlang der Ablöseebene (8) ausbreitet, und wobei durch den Riss die Festkörperschicht (4) von dem Festkörper (2) abgetrennt wird;
wobei der weitere Werkstoff (40) als Beschichtung auf das Polymer (39) aufgebracht ist oder das Polymer (39) als Beschichtung auf den weiteren Werkstoff (40) aufgebracht ist;
oder wobei der weitere Werkstoff (40) in Form von länglichen Elementen, insbesondere Spänen, innerhalb einer von dem Polymer (39) vorgegebenen Schichtstruktur vorgesehen ist, wobei die Elemente, insbesondere die Späne, bevorzugt derart ausgerichtet sind, dass sich ihrer Längsachse orthogonal zur Schichterstreckungsrichtung erstreckt;
oder wobei die Aufnahmeschicht (10) eine Vielzahl an Löchern (36) aufweist, wobei die Löcher (36) mit dem weiteren Werkstoff (40) gefüllt oder ausgekleidet sind.

2. Verfahren nach Anspruch 1,
wobei die Beschichtung lokale Schwächungen aufweist, insbesondere gebrochen ist, um einer durch das Polymer (39) bei der Spannungserzeugung bewirkten Verformung zu folgen.

3. Verfahren nach einem der vorangegangenen Ansprüche,
wobei die Wärmeleitfähigkeit (W/(m*K)) des weiteren Werkstoffs (40) mehr als 5 mal größer, bevorzugt mehr als 10 mal größer und besonders bevorzugt mehr als 30, mehr als 100, mehr als 200 oder mehr als 300 mal, größer als die des Polymers (39) ist, wobei der weitere Werkstoff (40) bevorzugt ein Metall oder eine Legierung ist.

4. Verfahren nach einem der vorangegangenen Ansprüche,
wobei die Löcher (36) einen Durchmesser von weniger als 1mm, bevorzugt von weniger als 0,5mm und besonders bevorzugt von weniger als 0,1mm, aufweisen.

5. Verfahren nach Anspruch 4,
wobei die Aufnahmeschicht (10) mehr als 10 Löcher (36), bevorzugt mehr als 100 Löcher (36) und besonders bevorzugt mehr als 1000 Löcher (36), aufweist.

6. Verfahren nach einem der vorangegangenen Ansprüche,
wobei in einem Radius von weniger als 50mm, bevorzugt weniger als 25mm und besonders bevorzugt weniger als 5mm, um das Zentrum eines jeden Loches (36) herum mindestens ein weiteres Loch (36) ausgebildet ist.

7. Verfahren nach einem der vorangegangenen Ansprüche,
wobei zum Ablösen der Aufnahmeschicht (10) von dem Festkörper (2) oder der Festkörperschicht (4) ein Fluid, insbesondere eine Flüssigkeit, durch die Löcher (36) einer Verbindungsschicht (11) zuführbar ist, durch welche die Aufnahmeschicht (10) an dem Festkörper (2) oder der Festkörperschicht (4) fixiert ist, wobei das Fluid bewirkt, dass die Fixierung der Aufnahmeschicht (10) an dem Festkörper (2) oder an der Festkörperschicht (4) geschwächt oder aufgehoben wird.

8. Anordnung mit einer Aufnahmeschicht, aufweisend:
einen Festkörper (2) mit einer durch Defekte in einer inneren Struktur des Festkörpers (2) vorgegebenen Ablöseebene (8), wobei die Defekte mittels mindestens eines Femtosekunden-Lasers, vor oder nach dem Anbringen der Aufnahmeschicht (10) an dem Festkörper (2) erzeugt wurden; und
der Aufnahmeschicht (10) auf einer Oberfläche des Festkörpers (2),
wobei die Aufnahmeschicht (10) zumindest aus einem Polymer (39) und einem weiteren Werkstoff (40) besteht, wobei das Polymer (39) nach dem Abkühlen der Aufnahmeschicht (10) auf oder unter eine Umgebungstemperatur derart, dass ein Polymerstoffanteil der Aufnahmeschicht (10) einen Glasübergang erfährt zum, insbesondere mechanischen, Erzeugen von Spannungen in dem Festkörper (2) geeignet ist, wobei sich durch die Spannungen ein Riss in dem Festkörper (2) entlang der Ablöseebene (8) ausbreitet, und wobei durch den Riss die Festkörperschicht (4) von dem Festkörper (2) abgetrennt wird und wobei der weitere Werkstoff (40) eine höhere Wärmeleitfähigkeit als das Polymer (39) aufweist;
wobei der weitere Werkstoff (40) als Beschichtung auf das Polymer (39) aufgebracht ist oder das Polymer (39) als Beschichtung auf den weiteren Werkstoff (40) aufgebracht ist; oder wobei der weitere Werkstoff (40) in Form von länglichen Elementen, insbesondere Spänen, innerhalb einer von dem Polymer (39) vorgegebenen Schichtstruktur vorgesehen ist, wobei die Elemente, insbesondere die Späne, bevorzugt derart ausgerichtet sind, dass sich ihrer Längsachse orthogonal zur Schichterstreckungsrichtung erstreckt;
oder wobei die Aufnahmeschicht (10) eine Vielzahl an Löchern (36) aufweist, wobei die Löcher (36) mit dem weiteren Werkstoff (40) gefüllt oder ausgekleidet sind.

9. Folie (10) zur Spannungserzeugung in einem Festkörper,
wobei die Folie (10) zumindest aus einen Polymerwerkstoff (39), insbesondere PDMS, und aus einem weiteren Werkstoff (40) besteht, wobei die Folie (10) volumenmäßig mehrheitlich aus dem Polymerwerkstoff (39) besteht, wobei der weitere Werkstoff (40) eine höhere Wärmeleitfähigkeit als der Polymerwerkstoff aufweist, wobei der Polymerwerkstoff (39) einen Glasübergang bei einer Temperatur unter 0°C, insbesondere bei einer Temperatur unter -50°C, erfährt;
wobei der weitere Werkstoff (40) als Beschichtung auf dem Polymerwerkstoff (39) aufgebracht ist oder der Polymerwerkstoff (39) als Beschichtung auf den weiteren Werkstoff (40) aufgebracht ist;
oder wobei der weitere Werkstoff (40) in Form von länglichen Elementen, insbesondere Spänen, innerhalb einer von dem Polymerwerkstoff (39) vorgegebenen Schichtstruktur vorgesehen ist, wobei die Elemente, insbesondere die Späne, bevorzugt derart ausgerichtet sind, dass sich ihrer Längsachse orthogonal zur Schichterstreckungsrichtung erstreckt;
oder wobei die Aufnahmeschicht (10) eine Vielzahl an Löchern (36) aufweist, wobei die Löcher (36) mit dem weiteren Werkstoff (40) gefüllt oder ausgekleidet sind.

10. Verwendung einer Folie gemäß Anspruch 9 als Aufnahmeschicht (10) in einem Verfahren nach Anspruch 1.

## Claims

1. Method for producing solid-state layers,
at least comprising the steps of:
providing a solid-state body (2) for the separation of at least one solid-state layer (4),
disposing a receiving layer (10) for holding the solid-state layer (4) on the solid-state body (2), the receiving layer (10) consisting at least of a polymer (39) and of a further material (40), the further material (40) having a higher temperature conductivity than the polymer (39),
generating defects in the internal structure of the solid-state body (2) for predefining a detachment plane (8) by means of at least one femtosecond laser, before or after the attachment of the receiving layer (10) on the solid-state body (2),
and subsequently cooling the receiving layer (10) to or below an ambient temperature in such a way that a polymer fraction of the receiving layer (10) undergoes a glass transition for the generation, more particularly mechanical generation, of stresses in the solid-state body (2), the stresses causing a crack to propagate in the solid-state body (2) along the detachment plane (8), and the crack causing the solid-state layer (4) to separate from the solid-state body (2) ;
wherein the further material (40) is applied as a coating on the polymer (39) or the polymer (39) is applied as a coating on the further material (40);
or wherein the further material (40) is provided in the form of elongate elements, more particularly chips, within a layer structure predefined by the polymer (39), the elements, more particularly the chips, being preferably aligned in such a way that their longitudinal axis extends orthogonally to the direction of layer extent;
or wherein the receiving layer (10) has a multiplicity of holes (36), the holes (36) being lined or filled with the further material (40).

2. Method according to Claim 1,
wherein
the coating has local weak points, and more particularly is broken, in order to follow a deformation brought about by the polymer (39) when the stresses are generated.

3. Method according to either of the preceding claims,
wherein
the thermal conductivity (W/ (m*K)) of the further material (40) is more than 5 times greater, preferably more than 10 times greater and more preferably more than 30, more than 100, more than 200 or more than 300 times greater than that of the polymer (39), the further material (40) preferably being a metal or an alloy.

4. Method according to any of the preceding claims,
wherein
the holes (36) have a diameter of less than 1 mm, preferably of less than 0.5 mm and more preferably of less than 0.1 mm.

5. Method according to Claim 4,
wherein
the receiving layer (10) has more than 10 holes (36), preferably more than 100 holes (36) and more preferably more than 1000 holes (36).

6. Method according to any of the preceding claims,
wherein
in a radius of less than 50 mm, preferably less than 25 mm and more preferably less than 5 mm, around the centre of each hole (36) there is at least one further hole (36).

7. Method according to any of the preceding claims,
wherein
to detach the receiving layer (10) from the solid-state body (2) or the solid-state layer (4), a fluid, more particularly a liquid, can be supplied through the holes (36) of a connecting layer (11) by which the receiving layer (10) is fastened on the solid-state body (2) or the solid-state layer (4), the effect of the fluid being that the fastening of the receiving layer (10) on the solid-state body (2) or on the solid-state layer (4) is weakened or undone.

8. Arrangement having a receiving layer, comprising:
a solid-state body (2) having a detachment plane (8) predefined by defects in an internal structure of the solid-state body (2), the defects having been generated by means of at least one femtosecond laser, before or after the attachment of the receiving layer (10) on the solid-state body (2); and
of the receiving layer (10) on a surface of the solid-state body (2),
wherein the receiving layer (10) consists at least of a polymer (39) and of a further material (40), the polymer (39) being suitable, after the cooling of the receiving layer (10) to or below an ambient temperature in such a way that a polymer fraction of the receiving layer (10) undergoes a glass transition, for the generation, more particularly mechanical generation, of stresses in the solid-state body (2), the stresses causing a crack to propagate in the solid-state body (2) along the detachment plane (8), and the crack causing the solid-state layer (4) to separate from the solid-state body (2), and the further material (40) having a higher thermal conductivity than the polymer (39) ;
wherein the further material (40) is applied as a coating on the polymer (39) or the polymer (39) is applied as a coating on the further material (40);
or wherein the further material (40) is provided in the form of elongate elements, more particularly chips, within a layer structure predefined by the polymer (39), the elements, more particularly the chips, being preferably aligned in such a way that their longitudinal axis extends orthogonally to the direction of layer extent;
or wherein the receiving layer (10) has a multiplicity of holes (36), the holes (36) being lined or filled with the further material (40).

9. Sheet (10) for generating stresses in a solid-state body,
wherein the sheet (10) consists at least of a polymer material (39), more particularly PDMS, and of a further material (40), the sheet (10) consisting in volume terms on a majority basis of the polymer material (39), the further material (40) having a higher thermal conductivity than the polymer material, and the polymer material (39) undergoing a glass transition at a temperature below 0°C, more particularly at a temperature below -50°C;
wherein the further material (40) is applied as a coating on the polymer material (39) or the polymer material (39) is applied as a coating on the further material (40);
or wherein the further material (40) is provided in the form of elongate elements, more particularly chips, within a layer structure predefined by the polymer material (39), the elements, more particularly the chips, being preferably aligned in such a way that their longitudinal axis extends orthogonally to the direction of layer extent;
or wherein the receiving layer (10) has a multiplicity of holes (36), the holes (36) being lined or filled with the further material (40).

10. Use of a sheet according to Claim 9 as a receiving layer (10) in a method according to Claim 1.

## Revendications

1. Procédé de fabrication de couches de corps solide, comprenant au moins les stades :
on se procure un corps (2) solide pour la séparation d'au moins une couche (4) de corps solide ;
on met une couche (10) de réception pour la retenue de la couche (4) de corps solide sur le corps (2) solide, la couche (10) de réception étant constituée au moins d'un polymère (39) et d'un autre matériau (40), l'autre matériau (40) ayant un coefficient de conductibilité thermique plus grand que celui du polymère (39),
on produit des défauts dans la structure intérieure du corps (2) solide pour la prescription d'un plan (8) de détachement au moyen d'au moins un laser à femtoseconde avant ou après la mise de la couche (10) de réception sur le corps (2) solide ;
et ensuite on refroidit la couche (10) de réception à ou en-dessous d'une température ambiante de manière à ce qu'une proportion de polymère de la couche (10) de réception subisse une transition à l'état vitreux pour la production, notamment mécanique, de tensions dans le corps (2) solide, dans lequel par les tensions une fissure se propage dans le corps (2) solide le long du plan (8) de détachement, et dans lequel par la fissure on sépare la couche (4) de corps solide du corps (2) solide,
dans lequel l'autre matériau (40) est déposé sous la forme d'un revêtement sur le polymère (39) ou le polymère (39) est déposé sous la forme d'un revêtement sur l'autre matériau (40) ;
ou dans lequel l'autre matériau (40) est prévu sous la forme d'éléments oblongs notamment de copeaux dans une structure stratifiée donnée à l'avance par le polymère (39), les éléments, notamment des copeaux, étant orientés de préférence de manière à ce que leur axe longitudinal soit orthogonal à la direction dans laquelle la couche s'étend ;
ou dans lequel la couche (10) de réception a une pluralité de trous (36), les trous (36) étant remplis ou habillés de l'autre matériau (40).

2. Procédé suivant la revendication 1,
dans lequel
le revêtement a des affaiblissements locaux, en étant notamment interrompu, pour qu'il se produise une déformation provoquée par le polymère (39) lors de la production de tensions.

3. Procédé suivant l'une des revendications précédentes,
dans lequel
le coefficient (W/ (m*K)) de conductibilité thermique de l'autre matériau (40) est plus de 5 fois plus grand, de préférence 10 fois plus grand et, d'une manière préférée, plus de 30 fois plus grand, plus de 100 fois, plus de 200 fois ou plus grand ou plus de 300 fois plus grand que celui de polymère (39), l'autre matériau (40) étant de préférence un métal ou un alliage.

4. Procédé suivant l'une des revendications précédentes,
dans lequel
les trous (36) ont un diamètre de moins de 1 mm, de préférence de moins de 0,5 mm et, d'une manière particulièrement préférée, de moins de 0,1 mm.

5. Procédé suivant la revendication 4,
dans lequel
la couche (10) de réception a plus de 10 trous (36), de préférence plus de 100 trous (36) et, d'une manière particulièrement préférée, plus de 1000 trous (36).

6. Procédé suivant l'une des revendications précédentes,
dans lequel
au moins un autre trou (36) est constitué autour du centre de chaque trou (36) dans un rayon de moins de 50 mm, de préférence de moins de 25 mm et, d'une manière particulièrement préférée, de moins de 5 mm.

7. Procédé suivant l'une des revendications précédentes,
dans lequel
pour la séparation de la couche (10) de réception du corps (2) solide ou de la couche (4) du corps solide, un fluide, notamment un liquide, peut être envoyé dans les trous (36) d'une couche (11) de liaison par laquelle la couche (10) de réception est fixée au corps (2) solide ou à la couche (4) du corps solide dans lequel le fluide fait que la fixation de la couche (10) de réception au corps (2) solide ou à la couche (4) du corps solide est affaiblie ou supprimée.

8. Montage ayant une couche de réception, comportant :
un corps (2) solide ayant un plan (8) de détachement prescrit par des défauts dans une structure intérieure du corps (2) solide, les défauts ayant été produits au moyen d'au moins un laser à femtoseconde avant ou après la mise de la couche (10) de réception sur le corps (2) solide ; et
la couche (10) de réception sur une surface du corps (2) solide,
dans lequel la couche (10) de réception est constituée d'au moins un polymère (39) et d'un autre matériau (40), dans lequel le polymère (39), après le refroidissement de la couche (10) de réception à ou en-dessous d'une température ambiante de manière à ce qu'une proportion du polymère de la couche (10) de réception subisse une transition à l'état vitreux, étant propre à la production, notamment mécanique, de tensions dans le corps (2) solide, dans lequel par les tensions une fissure dans le corps (2) solide se propage le long du plan (8) de détachement, et dans lequel par la fissure, la couche (4) de corps solide est séparée du corps (2) solide et dans lequel l'autre matériau (40) a un coefficient de conductibilité thermique plus grand que celui du polymère (39) ;
dans lequel l'autre matériau (40) est déposé sous la forme d'un revêtement sur le polymère (39) ou le polymère (39) est déposé sous la forme d'un revêtement sur l'autre matériau (40) ou dans lequel l'autre matériau (40) est prévu sous la forme d'éléments oblongs notamment de copeaux au sein d'une structure stratifiée donnée à l'avance par le polymère (39),dans lequel les éléments, notamment les copeaux, sont orientés de préférence de manière ce que leur axe longitudinal soit orthogonal à la direction dans laquelle la couche s'étend,
ou dans lequel la couche (10) de réception a une pluralité de trous (36), les trous (36) étant remplis ou habillés de l'autre matériau (40).

9. Feuille (10) de production de tensions dans un corps solide,
dans laquelle la feuille (10) est en au moins un matériau (39) polymère, notamment en un PDMS, et en un autre matériau (40), la feuille (10) étant constituée en volume majoritairement du matériau (39) polymère, l'autre matériau (40) ayant un coefficient de conductibilité thermique plus grand que celui du matériau polymère, le matériau (39) polymère subissant une transition à l'état vitreux à une température inférieure à 0 °C, notamment à une température inférieure à -50 °C ;
dans laquelle l'autre matériau (40) est déposé sous la forme d'un revêtement sur le matériau (39) polymère ou le matériau (39) polymère est déposé sous la forme d'un revêtement sur l'autre matériau (40) ;
ou dans laquelle l'autre matériau (40) est prévu sous la forme d'éléments oblongs, notamment de copeaux, au sein d'une structure stratifiée donnée à l'avance par le matériau (39) polymère, dans laquelle les éléments, notamment des copeaux, sont de préférence orientés de manière à ce que leur axe longitudinal soit orthogonal à la direction dans laquelle la couche s'étend ;
ou dans laquelle la couche (10) de réception a une pluralité de trous (36), les trous (36) étant remplis ou habillés de l'autre matériau (40).

10. Utilisation d'une feuille suivant la revendication 9 comme couche (10) de réception dans un procédé suivant la revendication 1.
